# EUROPEAN PATENT APPLICATION

(11) **EP 2 336 792 A1**
(43) Date of publication of application: **22.06.2011**
(21) Application number: 10195189.5
(22) Date of filing: 15.12.2010
(51) Int. Cl.: G01R 22/06, G01D 4/00, G06Q 50/00

(54) **Device and method for monitoring consumption and/or production of electrical energy**

(30) Priority: 15.12.2009 IT PD20090374
(71) Applicant: 4-Noks S.r.l., 31010 Godega di Sant'Urbano (TV) (IT)
(72) Inventor: Marchetti, Corrado, 31052 VARAGO DI MASERADA SUL PIAVE (T (IT); Ciullo, Giancarlo, 31025 SANTA LUCIA DI PIAVE (TV) (IT)
(74) Representative: Montevecchi, Emma

(57) **Abstract**

The invention relates to a device (1) for monitoring the consumption and/or production of electrical energy, such a device being intended to be coupled to an energy generation plant (100), on the one hand, and to an electrical energy meter (CE) on the other hand, the meter (CE) including at least one light source, the source emitting a light pulse as a function of the quantity of electrical energy produced and/or consumed, comprising: an optical interface (2), suitable for being fixed to the electrical energy meter (CE) next to the light source, the interface (2) including a sensor (15) suitable for detecting the pulses emitted by the light source installed on the electrical energy meter (CE) and for transmitting a signal in the presence of a pulse; a pulse counter (3) coupled to the interface (2), suitable for counting the number of pulses of the light source based on the signal sent by the interface (2) and suitable for calculating the consumption and/or production of electrical energy over a defined unit of time; processing and transmission means (4) coupled to the pulse counter (3); and a display unit (5), the processing and transmission means (4) being suitable for sending the data, related to the pulse count and to the consumption and/or production of electrical energy, to the unit (5); and an auxiliary sensor (104) suitable for detecting the quantity of energy available at the energy generation plant (100) in a manner independent of the plant and comparing the energy available with that actually transformed and passed on to the electronic meter (CE).

The invention also relates to a method for monitoring the consumption and/or production of electrical energy.

## Description

### Technical field of the invention

The present invention relates to a device, a method and a plant for monitoring the consumption and production of electrical energy when connected to an energy generation plant. In particular, the device of the present invention is suitable for being coupled to an electrical energy meter, supplied at every electrical plant by the main energy distribution companies, and for sending a signal related to the consumption and/or production of energy over a defined time interval, and therefore displaying such data; at the same time the device detects signals from an auxiliary sensor so as to be able to detect faults in the operation of the plant and if necessary raise the alarm.

### Technological background

The desire to improve energy efficiency and monitor consumption, either in a domestic environment or in an industrial environment, is a need particularly felt nowadays, for both economic and environmental reasons. In particular, it is advantageous to be able to know the actual consumption in real and accurate time, i.e. to know the electrical energy actually consumed in a manner comparable with the measurements carried out by the electrical power grid operator. Indeed, a knowledge of actual consumption, as has been demonstrated, might stimulate the user to reduce consumption or prevent momentary interruptions to the energy supply from taking place in the event that limits of maximum power absorbed within a certain time interval are exceeded.

Always for the purposes of limiting energy consumption, photovoltaic plant installations are being distributed more and more in both industrial and domestic environments. As is known, the electrical energy produced by these plants can be used either inside the house/building to which the photovoltaic plant is connected, or it can be fed into the electrical power grid and basically "sold" to the operator of that grid.

In some countries, for example in Italy, the metering of electrical energy produced by the photovoltaic plant and fed into the electrical power grid is carried out by a meter positioned downstream of the inverter relative to the plant, which meters all the energy produced by the latter. Further along, there is another meter which measures the current fed into the grid. Such a meter can be separate or the same as that which is installed for the metering of the electric current drawn from the grid and consumed, i.e. in some cases the same meter functions in both directions (it is bidirectional). In the latter situation, the single meter carries out both the energy supply measurements (i.e. it measures the quantity of energy drawn from the grid) and the energy feed measurements (i.e. it measures the quantity of electrical energy produced by the photovoltaic plant, i.e. a portion of the total energy produced by the latter, fed into the energy grid).

A need has arisen for monitoring over time the production of electricity and therefore the efficiency of the aforementioned photovoltaic plants. Even for this type of measurement, as in the case of measuring the quantity of energy drawn from the grid, it is vital that it is consistent with the measurements carried out by the electrical energy operator, i.e. with the measurement carried out by the meter, which measurement is the only one considered "reliable". In particular, the electronic meter installed by the energy management and distribution company, for example ENEL S.p.A., is the only measurement device certified for the purposes of energy production or consumption; indeed, no other type of measurement device inserted outside or inside the apparatus forming for example part of the photovoltaic plant, in the case of production, or other measurement devices placed in series with the meter in the case of consumption measurement, are authoritative.

From DE 20 2008 007 959 U1,it is known how to apply to the meter a reader of a signal correlated with the consumption of energy which passes through the meter. In DE '959, such a reader comprises an optical interface suitable for detecting light pulses signifying the energy passing through the meter and for transferring the detected data to a processing system which supplies, based on the pulse count, an indication of the consumption of electrical energy at the meter.

This device meets the measurement requirements pointed out above but does not supply any useful indication on the management of a possible generation plant (wind or photovoltaic) associated with it, in particular in the event of a fault thereof.

It is also known how to monitor the operating parameters of a generation plant at the inverter, which must in this case be appropriately arranged and equipped to perform such monitoring. In known plants, the function for monitoring correct operation of the plant is however possible only if special inverters are adopted, i.e. if the inverter which equips the generation plant is replaced by one of a suitable type. Without this special arrangement, the user is probably not in a position to detect occasional malfunctions, i.e. those only partly invalidating the production of energy. This is clearly an undesirable effect since it compromises efficiency and also the economics of the investment.

### Summary of the invention

An object of the present invention is therefore that of making available a device and a method for meeting the requirements referred to above, making available a measurement of consumption and/or production of electrical energy which are accurate and perfectly comparable with that measured by the meter supplied by the electrical energy operator (for example the ENEL electronic meter, although the invention can be coupled to any other meter), ensuring at the same time a quick check of the efficiency of any generation plant associated with it without however requiring inverters and other specifically arranged equipment.

This object is achieved by means of a device, a method and a plant for monitoring the consumption and/or production of electrical energy, which are realised in accordance with the claims that follow. It is to be emphasised that the invention does not alter in any way the meter of the electrical energy operator, not modifying in any way its operation or its casing.

This object and others which will become clearer hereafter are achieved by a method and a device for monitoring the consumption and/or production of electrical energy in accordance with the claims that follow.

### Brief description of the drawings

The following examples better illustrate the features and advantages of the invention which are described by way of indication and in a non-limiting manner with reference to the appended drawings in which:
- Figure 1 is a schematic perspective view of an element of the device produced according to the invention in a disassembled state and close to a meter supplied by the electrical energy operator;
- Figure 2 is a schematic perspective view of an element of the device produced according to the invention, of Figure 1, and coupled to the meter supplied by the electrical energy operator;
- Figures 3 and 4 represent two perspective views from two different angles of the element of the device of Figure 1 in a disassembled state;
- Figure 5 represents the element of the device 1 in a disassembled state;
- Figure 6 represents a schematic perspective view of the device according to the invention, coupled to the electrical energy meter;
- Figure 7 represents a second preferred example of the device of Figure 6;
- Figure 8 represents a block diagram of the device according to the invention of Figure 6 or 7;
- Figure 9 represents a block diagram of a second preferred example of the device of the invention;
- Figure 10 represents a block diagram of a third preferred example of the device of the invention;
- Figure 11 represents an example view of a preferred example of use of the device of the invention;
- Figure 12 represents an energy generation plant coupled to the device produced according to the invention;
- Figure 13 represents a further example embodiment of the plant of Figure 12;
- Figure 14 represents a perspective view of a detail of the device according to the invention;
- Figure 15 represents a view of an alarm signal related to a stage in the method according to the invention;
- Figures 16 and 17 represent two possible displays of parameters measured by means of the device of the invention.

### Descriptions of one of more preferred examples of the invention

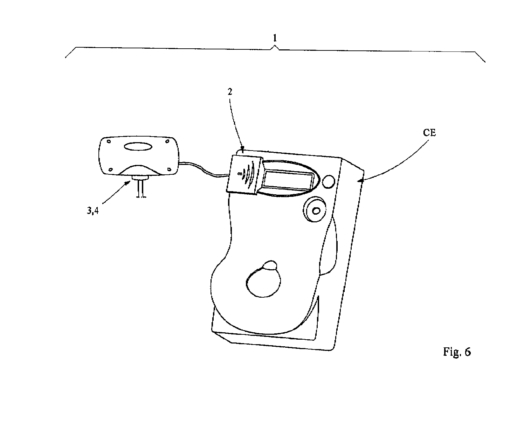

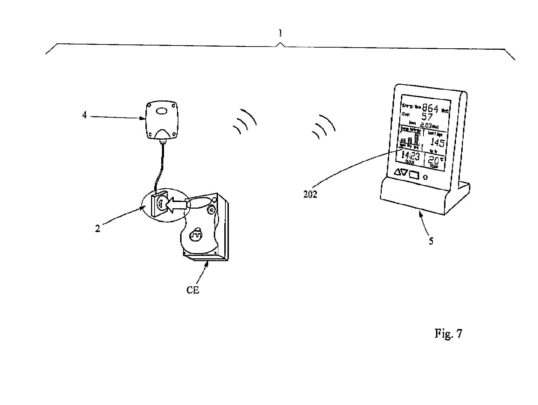

With initial reference to Figures 6 and 7, the reference 1 indicates in an overall sense a device for monitoring the consumption and/or production of electrical energy, which device is produced in accordance with the present invention.

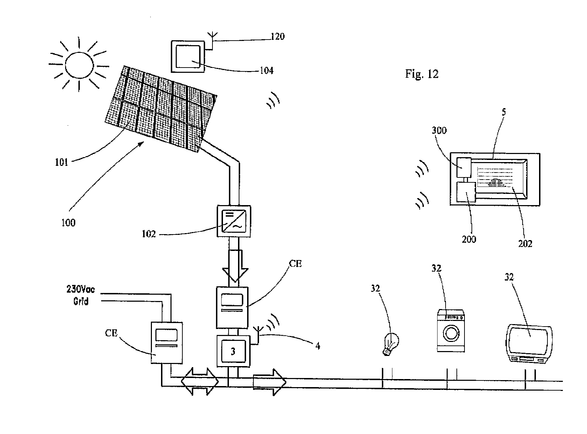

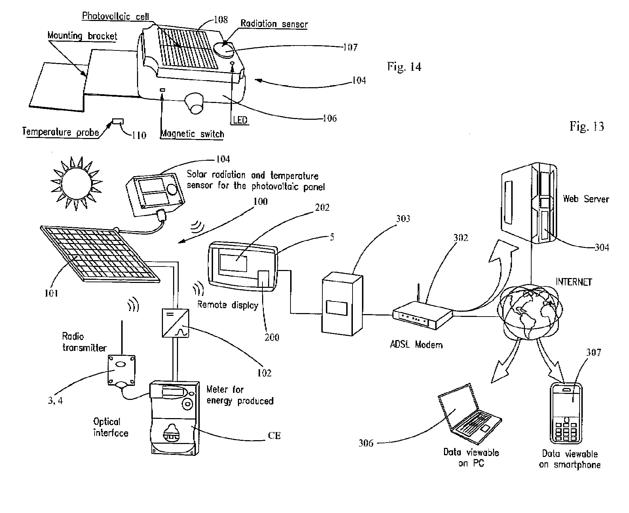

The device 1 is used in association with an energy generation plant 100 (see appended Figures 12 and 13), such as a photovoltaic plant including a plurality of photovoltaic panels 101 or a wind turbine including one or more wind generators (example embodiment not represented in the appended drawings). The energy generation plant 100 produces DC electrical energy which is supplied to an inverter 102 to be used in AC form of appropriate frequency by the domestic user and/or fed into the grid. Hereinafter, reference will be made by way of example to a photovoltaic plant, it being understood that what is described applies equally to plants of different type, for example wind turbines.

The device 1 comprises the following elements: an optical interface 2 suitable for being coupled to an electronic meter CE produced in accordance with the instructions of the electrical energy operator company (for example an ENEL electronic meter, although any meter of any operator can be used), a pulse counter 3, processing and transmission means 4 and a display unit 5, each of which will be detailed later.

Also part of the device 1 is an auxiliary sensor 104, including a radiation sensor in the case of a photovoltaic plant or an anemometer in the case of a wind turbine, suitable for detecting the quantity of energy available at the energy generation plant 100 in a manner independent of said plant and comparing the energy nominally available with that actually produced and passed on to the electronic meter CE. The auxiliary sensor 104 also comprises signal transmission means 120, integral with or separate from the same sensor.

The device 1 is therefore coupled on the one hand to an electronic meter CE supplied by the electrical energy operator and installed beside any electrical plant, industrial or domestic, related for example to a building, so as to be able to detect its consumption or the production of energy if a photovoltaic plant 100 is arranged beside this electrical plant and coupled to it. Electrical and photovoltaic plants (or alternatively wind turbines) are known per se in the sector and coupled to each other in a known way. On the other hand, the device 1 is coupled to the energy generation plant 100.

The electronic meter CE can be either the meter which measures the quantity of electrical energy produced by the electrical energy generation plant 100 or the meter which measures the quantity of electrical energy consumed and drawn from the grid. Indeed, the operation of the device 1 is the same in both cases. Furthermore, the invention provides the capability of measuring both the electrical energy produced and that consumed, therefore being coupled to both meters. As mentioned above, since the electronic meter can also be bidirectional, provision is also made by the invention for the device 1 to be able to measure both the quantity of energy consumed and that fed, being applied to a single meter.

As is known, a present electronic meter CE produced and installed by ENEL S.p.A. (hereinafter referred to briefly as "electronic meter") includes two light emitters, in particular two LEDs,generating light pulses which are emitted as a function of the quantity of energy fed into the electrical grid or drawn from the same according to a fixed relationship which is communicated by the operator of the network. For example, in the case of meters up to 3 kW of power, typically a light pulse is generated by an LED of the meter every time the latter measures a consumption or an injection of one watt. In other words, a light pulse, or "flash",is emitted every W/h counted (at both input and output), i.e. there having been released a kW/h of energy consumption or injection into the grid every 1000 pulses of the LED. The optical interface 2 is suitable for detecting these light pulses emitted by the LED of the electronic meter and is therefore coupled to the meter CE so as to intercept with certainty every single light pulse and emit a resulting output straight to the pulse counter 3, as detailed later.

In present-day ENEL meters, the pulse-emitting LEDs are generally two in number, one of which measures of the active power and the other the reactive power; for the purposes of monitoring the billing, the only useful measurement is that of the active power, and therefore the optical interface is positioned beside that LED; however the device of the invention 1 can be adapted to detect both pulses emitted separately by the two LEDs.

In more detail, the optical interface 2 is positioned on the body of the meter CE in such a position as to intercept the light signals produced by at least one of the two (or more) the light emitters of the meter CE. Clearly, provision is made for the meter CE to be able to be equipped with different light signal sources, and not only LEDs, in which case a corresponding optical interface suitable for detecting the different pulse is provided by the present invention. The signal emitted by the meter CE can hence be of any type.

For the purpose of the abovementioned detection, the optical interface 2 comprises at least one optical sensor 15, such as for example a photodiode, with a spectral sensitivity to the light emitted by the light emitter (such as the red light emitted by the LED) of the meter CE. The light pulses are emitted by the LED (or LEDs) of the meter in a manner proportional to the energy recorded by the meter and the pulse/energy relationship is made known by the electrical energy operator.

The optical sensor 15 is appropriately polarised so as to be as far as possible insensitive to ambient luminosity, both natural and artificial; said luminosity is further shielded by the structure of the same interface 2, as detailed later.

If two electronic meters CE are present, the device according to the invention 1 provides for positioning an optical interface 2 either on the consumption meter, or on the meter measuring the energy production, beside the respective light emitters.

The optical interface 2 is coupled to the meter (or meters) CE for example by means of two strips of double-sided tape.

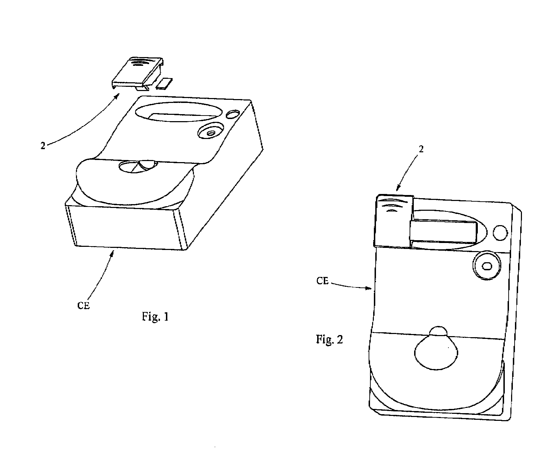

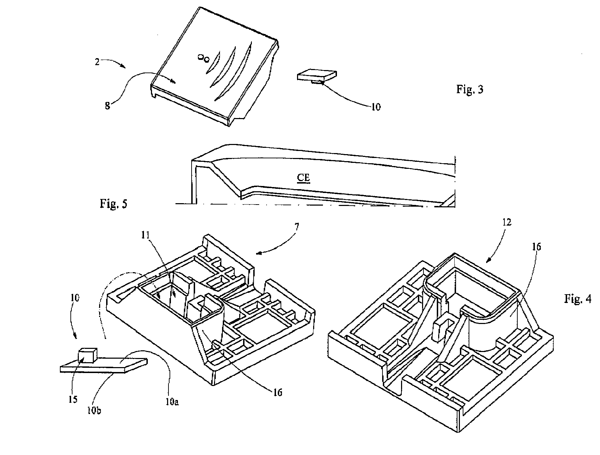

The optical interface 2 (see in detail Figures 3 to 5 for a detail of individual components, and Figures 1 and 2 for an overview) comprises a support 7, including a plate-like element 8 having the function of light shield and a receiving seat 11 for a board 10, which seat in addition to receiving the board has the function of further shielding the external ambient light in such a way that the detection of the light pulses of the meter is not disturbed or carried out erroneously due to light sources that are different from the source present in the meter CE.

The board 10 comprises the optical sensor 15 and its circuitry (not shown). The board 10 is coupled to the plate-like element 8 by means of the seat 11 1 in such a way that the board and plate-like element are substantially parallel with each other. The board 10, which defines a first and a second face 10a, 10b, opposed to one another, is therefore located with one face 10b presented to the plate-like element 8 and with the other face 10a presented to the LED of the meter CE.The interface 2 is positioned on the meter CE in such a way that the optical sensor 15 is positioned substantially in front of the LED.

So as to shield the external light in the best way possible, in addition to the plate-like element 8 in parallel with the board, the seat 11 includes a tubular body 16 made of a material that is not transparent to the relevant light radiation and which is extended perpendicularly to the plate-like element 8. The board 10 substantially forms the base of the tubular body 16, on the side opposite the element 8 which can be considered to form the opposite base. The board 10 is therefore surrounded on all sides, except the side including the sensor 15 presented to the meter CE, by shielding walls (the tubular body 16 or the plate-like element 8).

With the signal having been detected by the sensor 15, a comparator (not depicted), to which there are provided as input a fixed voltage threshold and the variable voltage produced by the sensor 15 in relation to the light pulse detected, converts the pulses from the sensor 15 into a digital electrical signal and makes it available to the pulse counter 3 and therefore to the processing and transmission means 4.

The connection between the optical interface 2 and the pulse counter 3 is formed by a shielded cable.

The pulse counter 3 receives the electrical pulses sent by the optical interface 2 connected to the meter CE and executes the function for counting them. More specifically, it counts the electrical pulses and integrates them over a given unit of time supplying either the total energy counted by the meter or the electrical power measured over a given unit of time (for example two minutes). The integration time is chosen to adapt to the requirements of fast updating of the power data and of high resolution in the measurement, for example although it can be equal to two minutes, it is nevertheless possible to modify it based on the requirements.

In the electronic meter CE for example, a counter is present which automatically increments continuously; it is also possible that this counter is reset in defined circumstances. The counter 3 of the present invention can carry out a reset and start again from a value equal to zero at any moment for example to realign itself with the measurement of the meter CE.

The counter 3 can reside inside the device that also deals with the transmission, the processing and transmission means 4, or it can be separate from it.

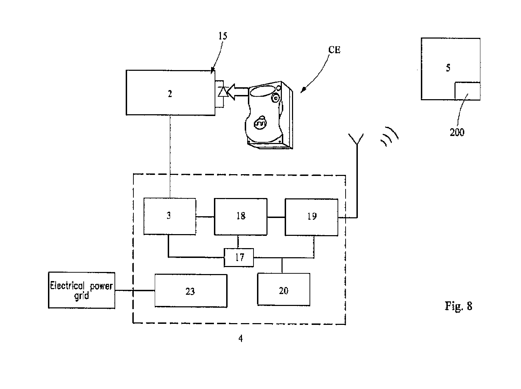

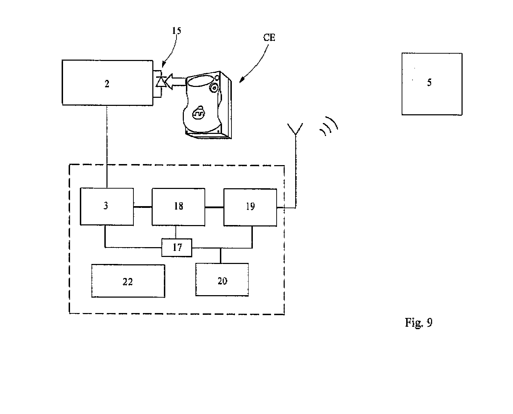

The device 1 can function with battery power and it can be supplied directly from the electrical power grid: Figures 8 and 9 depict the two separate example power supplies mentioned. In both the examples depicted, the counter 3 is coupled to the processing and transmission means 4.

If the electrical power grid is used, the device 1 preferably includes a power supply 23 suitable for feeding the device 1: it converts the 12-24 V voltage (for example present from another power supply which is generally present in a technical box, such as a doorbell transformer), both DC and AC or the 230 Vac mains voltage supplied to the input terminals, into the voltages required for the operation of the various internal circuits of the device 1.

In the battery device, the power supply 23 is replaced by a battery 22, as already mentioned, for example a long-lasting lithium cell.

The processing and transmission means 4 transmit, after any processing, in a manner described later, the information collected by the pulse counter 3 to the display unit 5. They 4 comprise a microprocessor 17, a memory 18 and a transmitter 19.

The microprocessor 17 processes the data from the counter 3 and is commanded by a user interface as detailed later.

In the case of battery-powered 22 processing and transmission means 4 (Figure 9), in a manner such that low consumption and therefore a long duration of the batteries is obtained, the device of the invention 1 uses the microprocessor 17, for example a microcontroller, in sleep mode: the electrical pulse from the optical interface 2 "wakes up" the microcontroller 17 for a time that is strictly necessary to accumulate the count, while for the remainder of the time it is switched off and therefore energy is not consumed; in the version powered by the electrical power grid, this mode is not necessary.

For the version powered by the grid, the pulse count would be lost upon a cut in the supply voltage, for example in the event of a sudden blackout; for this purpose, there has been inserted in the device of the invention a mains absence detector (not depicted) which operates by supplying a warning signal before the supply voltage falls below the minimum operating level of the device 1 in such a way that the data of the counter 3 in the memory 18, for example a non-volatile flash type memory, can be saved in time by the device 1.

The counter 3 saves within itself the data relating to the energy consumption and can at any time be set, via radio or power line communication, with the data reported on the electronic meter CE so as to align the two items of information.

The memory 18 is the circuit which in the event of a power cut physically memorises the counter 3 (i.e. it stores the data related to the energy count), or the number of pulses of the LED of the counter, and the configuration information such as the transmission time and other service-related information.

The processing and transmission means 4 also preferably include a user interface 20 which is suitable for displaying the state of the device 1 and for establishing the connection with the display unit 5. The user interface 20 comprises for example some LEDs which flash appropriately to display the correct operation of the connection between the means 4 and the unit 5, modifying the on/off ("flashing") arrangement of the LEDs according to whether the transmission is taking place correctly between the means 4 and the unit 5 or whether there is an error present (the latter can be for example signalled with a longer flash than that which takes place when there is normal transmission). Subsequently, the LEDs can be used in the first installation stage to pair up the means 4 and unit 5 with each other by virtue of a simple procedure and to check that the connection has occurred correctly (the unit 5 could be for example too far from the means 4 to be reached via radio).

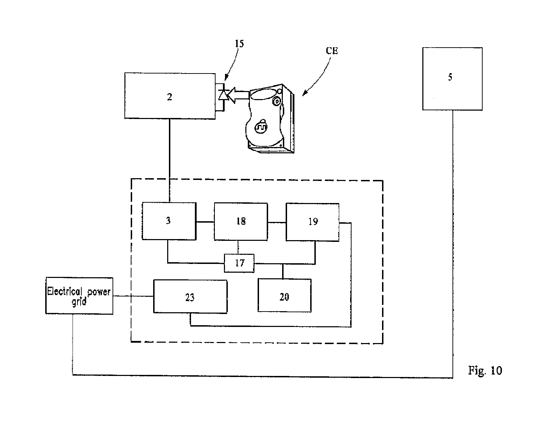

The means 4 also include a transmitter 19, for example an RX/TX radio device or a power line communication transmitter (see Figures 8 and 9 for preferred example embodiments using radio waves, and Figure 10 for an example embodiment with transmission by power line communication), which deals with periodically transmitting, preferably by means of one of the two technologies mentioned, radio or power line communication, the instantaneous power and total energy information to an external system, such as the display unit 5.

If the transmitter 19 is a power line communication transmitter, the power supply 23 is directly connected to the mains voltage at 230 Vac and also carries out the mains signal coupler functions.

The unit 5 can comprise a receiver device connected to an external PC-based supervisor or belonging to a home systems network, such as one based on PLC technology, or of another type, or it can include a simple processing and display terminal which deals with presenting the data to the user. In any case, the unit 5 comprises, both integrally and separated from it, further processing means (not represented) for the management, calculation and display of the data received. The data that can be viewed, for example in a special display 202, is the instantaneous power delivered (in the case of a meter that measures the energy produced by the energy generation plant 100) or consumed (in the case of the normal meter), or both, the total energy produced and consumed, and further data that can be derived therefrom, for example the energy of the last hour or of the last day or of the previous week, according to the demands, and appropriate comparative graphs and tables, etc. There can furthermore be displayed tables and graphs of the progress of the power/energy generated. Further data displayed is listed below with reference to a signal sent by the auxiliary sensor 104.

Subsequently, the unit 5 can receive and display data relating to the accuracy and to possible errors present in the data transmission between the means 4 and the unit 5.

There is arranged close to the power generation plants, for example a photovoltaic plant, the auxiliary sensor 104 (represented in the detail in Figure 14) which must be subjected to the same environmental conditions to which the same plant is subjected, i.e. in the case of a wind turbines the auxiliary sensor must be arranged such that it receives substantially the same flow of wind as on the blades of the generator, while in the case of a photovoltaic plant, the auxiliary sensor must be arranged such that the radiation to which it is subjected is substantially similar to that received by the photovoltaic panel 101.

In the preferred photovoltaic plant example depicted, the auxiliary sensor 104 includes a radiation sensor 107 fitted in a watertight box 106 which contains, in addition to the sensor 107, a small photovoltaic panel 108 to power the same auxiliary sensor, and a temperature sensor 109. The temperature sensor is applied to one of the photovoltaic panels 101 to detect the presence thereof. In the box 106, there is fitted a radio or power line communication transmitter 120 capable of remotely connecting with the processing and transmission means 4 and/or with the display unit 5. These means 120 can also however not be integral with the auxiliary sensor 104, but be only connected to the latter.

The auxiliary sensor 14 is preferably not a sensor for the accurate and precise measurement of solar radiation, for which particularly accurate and relatively expensive sensors would be necessary. The sensor used in the present invention establishes a relationship between an energy measurement carried out by it and the measurement made by the electrical energy meter CE via the optical interface 2. Thus, by means of a calibration operation described later, it is possible to free up the calculation performed from a series of factors such as the type and number of photovoltaic panels 101, the temperature thereof, the presence of any shade above said panels and any other causes of disturbance.

The auxiliary sensor therefore receives signals from the sensors incorporated in it (or in any case connected) at set sampling intervals (for example every 10 or 30 seconds) and, according to a different sampling rate (for example every 90 seconds in the daytime rate and every 270 seconds in the nighttime rate), it sends the signals to the display unit 5 by means of the transmission means 120.

The unit 5 therefore, in addition to the signals sent by the means 4, displays and processes the signals sent by the auxiliary sensor 104 via the means 120. According to the invention, one or more of the following data items can be displayed in the unit 5:
- an indication of the signal power of the transmission means 120, i.e.
   for example in the case of radio transmission, the power of the radio signal;
- the power value transmitted by the auxiliary sensor 104 (for example expressed in kW);
- the energy integrated over a day, i.e. the energy detected by the auxiliary sensor 104 over the current day;
- the luminosity detected by the auxiliary sensor;
- the temperature detected by the temperature sensor 109 arranged in the auxiliary sensor 104. A temperature reading that is too high can
   indicate a malfunctioning of the panels 101.

According to one feature of the invention, in the unit 5, the data from the pulse counter 3 associated with the optical interface 2 and the data from the auxiliary sensor 104 are compared with each other so as to be able to effectively identify any malfunctions of the energy generation plant 100.

In particular, in the unit 5, a relationship is established between the data received by the sensor 104 and the counter 3, and the efficiency of the plant 100 is calculated. The efficiencies calculated are for example:
Power efficiency: (average power calculated by the pulse counter 3 over a time T1)/(average power calculated by means of the auxiliary sensor 104 over a time T1);
Energy efficiency: (average energy calculated by the pulse counter over a time T2)/(average energy calculated by means of the auxiliary sensor 104 over a time T2);
for example T1 = one hour; T2 = one day.

These values are continuously calculated by the unit 5, for example every 15 minutes, and are displayed in the display 202.

The device 1 also comprises alarm means 300 preferably associated with the unit 5. The alarm 300 which can flag a possible malfunctioning of the plant 100 is activated when the power efficiency value defined above falls below a first threshold value which is set up (and which can be changed in the programming of the device 1). To minimise the possibility of an incorrect alarm, the alarm signal is emitted by the means 300 only if the communication between the auxiliary sensor 104 and the unit 5, and between the latter and the optical interface 2 connected to the counter 3, are both active and functioning. Furthermore, the power value calculated by the auxiliary sensor 104 must be above a second minimum threshold value which is also set up beforehand. All these data items related to the first and second threshold values can be modified, for example by means of an appropriate command menu present in the unit 5.

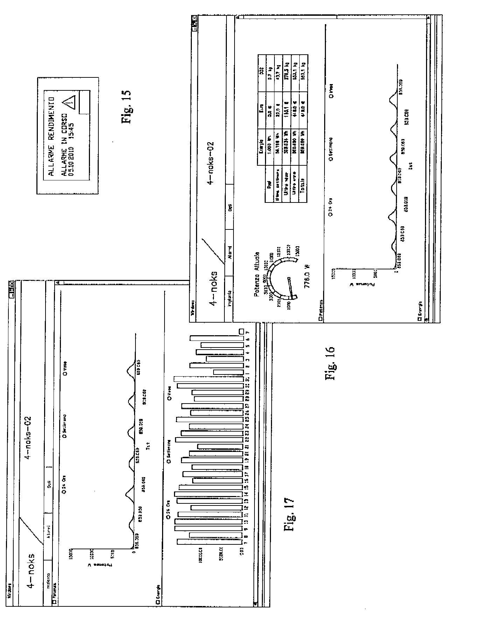

For example, on falling below this first power threshold, an alarm window can be opened in the unit 5 such as that displayed in Figure 15. Clearly, other types of alarm message can be contemplated, including visual or audible ones.

Furthermore if at a certain instant the power returns to above this first threshold value, the unit 5 can store and even keep the data items related to the time interval in which to device 1 was in an alarm state displayed. According to a further example embodiment of the device 1 represented in Figure 13, the device 1 provides for remotely monitoring via the Internet by means of an ADSL modem 302 or GPRS the operation of the energy generation plant 100. There is therefore arranged in the device 1 upstream of the modem (or element for connection to the Internet network) an accessory element 303 which collects the data from the unit 5 and transmits it to a web portal (for example housed in a web server 304). Transmission of these data items preferably takes place automatically via ADSL or a GPRS network. Access to the portal (in other words to a website) might be, for the owner and user of the plant 100 and, for example, the installer of the same plant, via a PC 306 connected to the Internet or via a smartphone 307 or other device capable of establishing such a connection with the web. In addition, if the alarm 300 is activated, the web portal can also flag faults with the automatic transmission of email or sms without requiring access to the same portal.

Alternatively or in addition, these items of information of the element 303 are made accessible also via an ethernet local network or a VPN, by means of a normal browser, enabling a historical download of data and the display of variables of the plant.

Variables of the plant which are displayed and stored remotely by the element 303 on the web portal are preferably:
- instantaneous power produced by the plant 100;
- peak power of the plant 100;
- energy produced, as defined above, by the plant 100;
- euros made by the plant (an average over a certain time interval);
- CO₂ saved (an average over a certain time interval);
- output in hours;
- solar radiation (in the case of a photovoltaic plant);
- alarms of the plant 100;
- efficiency of the plant 100;
- data update every interval T3, for example T3 = 15 minutes.

Preferably, all this data is continuously stored. This data can be even be displayed in a different way according to the user (an end-user or an installer), as displayed, for example, in Figures 16 and 17.

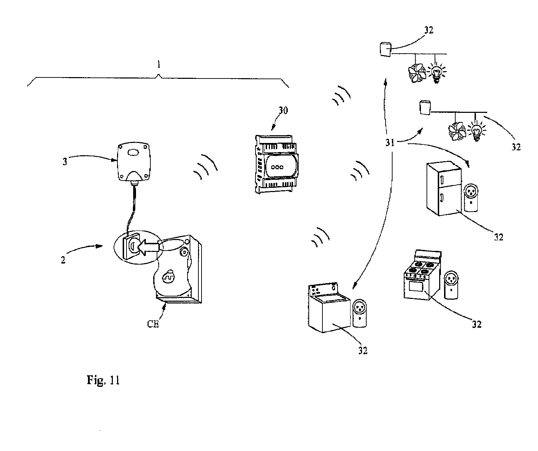

According to one variant of the invention depicted in Figure 11, the unit 5 includes a load management control unit 30, which manages a plurality of power sockets 31 using an ON/OFF procedure. If the device 1 detects that the power absorbed by the electrical plant to which the device 1 is coupled is greater than the preestablished threshold (variable according to the type of contract subscribed to with the electrical power grid operator company), the control unit 30 can deactivate, according to a preset command, a plurality of loads 32 connected to the electrical plant of the building in which the device 1 is installed. In the control unit 30, in particular inside one of its memories (not depicted), a list of priorities for the various loads is stored in such a way that, having exceeded the maximum threshold of power absorbed, the control unit sends a signal to the socket 31 to which the lowest "priority" load to be deactivated 32 is connected, interrupting the flow of current to that socket and thus reducing the power absorbed. It is possible to make provision for the same control unit 30 to reactivate the deactivated socket 31 as soon as the power absorbed falls to below a certain threshold, preferably such that even if the load 32 to be reactivated absorbs its maximum nominal power (the maximum power levels of each load can also be stored in the memory of the control unit 30), the maximum threshold set by the electrical power grid operator would nevertheless not be reached.

By means of the invention, it is also possible to monitor in real time the quantity of energy consumed monthly in the case of monthly fixed price contracts but which are linked to a maximum quantity of energy consumed. In this case, the device must obviously (also) be connected to the energy consumption meter.

The device 1 operates in the following way. The optical interface 2 reads the light pulses of the light emitter (or of the light sources), such as the LED, positioned on the meter. This signal is converted into a digital signal and is stored and counted by a counter 3. By means of the count over a defined period, it is possible to calculate the consumption (or the production of energy and therefore also the amount which will be received by the electrical power grid operator receiving the energy), either instantaneous consumption by integrating the data over a short time interval, or for example daily or monthly consumption. The calculation is simple in that the electrical power grid operator company supplies the relationship between the light pulses and the consumption, i.e. by knowing this data it is possible to immediately establish, having counted the pulses, how many kW/h they represent. The same calculation is possible when energy is sent by a photovoltaic plant to the electrical power grid: in this case the light pulses from the electrical meter CE represent the energy that is produced by the plant 100 and for which a defined sum will be paid by the electrical energy operator. These calculated quantities are sent via radio or via power line communication to a unit 5 suitable for displaying the data to the user or for processing the data, for example storing the pattern of energy consumption or production monthly or annually.

As regards the production of energy, any sudden drops thereof can be indicative of a failure of the plant 100, thus facilitating the monitoring of the plant itself. The auxiliary sensor 104 is capable of calibration in order to establish a due relationship between the energy measurement of the radiation sensor and the energy measurement available at the photovoltaic production meter, thus calculating the energy efficiency of the plant in terms of energy produced at the meter CE, downstream of inverters, panels and associated connections, with respect to the radiation available at the collectors, i.e. at the radiation sensor. The relationship obtained during calibration is saved in a non-volatile memory of the display unit.

The calibration must be carried out when the plant 100 is under normal operating conditions, and subjected to a solar radiation (or to a wind force in the case of wind turbines) which allows the plant to work at a good energy efficiency point (from 50% to 100% of the maximum power). The calibration process calculates the energy actually produced over a given time interval by the plant and that which can theoretically be produced over the same time interval, which interval is variable and can be fixed, for example one hour. Once calculated, the two energy values are correlated into a reference coefficient which is stored. By using this coefficient, the signal processing unit and/or display unit will be able to detect a possible shift from the conditions stored, flagging to the user by means of the alarm 300 a possible drop in energy efficiency.

With the calibration executed, the efficiency of the plant is recalculated at preestablished time intervals, for example every 15 minutes, on values averaged for example over one hour of operation.

The calibration process can be carried out at any time, even following activation of the plant, as long as the abovementioned conditions are met. An annual periodic recalibration could be particularly useful in order to keep up with the normal falls in efficiency due to the ageing of the photovoltaic modules 101; indeed a purpose of the system is to flag up in a timely manner a fault, or an external cause, which reduces substantially and suddenly the performance levels of the plant independently of the slow normal degradation in production plants using photovoltaic modules.

By means of the method of the invention, it is likewise possible to manage in the best way possible the loads 32 connected to the electrical plant, since the unit 5 can comprise a load management control unit 30 and deactivate the lowest-priority loads, as selected by the user, if the energy consumption is excessive or even greater than the threshold value set by the electrical energy operator.

## Claims

1. A device (1) for monitoring the consumption and/or production of electrical energy, such a device being intended to be coupled to an energy generation plant (100), on the one hand, and to an electrical energy meter (CE) on the other hand, the meter (CE) including at least one light source, said source emitting a light pulse as a function of the quantity of electrical energy produced and/or consumed, comprising:
- an optical interface (2), suitable for being fixed to the electrical energy meter (CE) next to the light source, said interface (2) including a sensor (15) suitable for detecting the pulses emitted by the light source installed on the electrical energy meter (CE) and for transmitting a signal in the presence of a pulse;
- a pulse counter (3) coupled to the interface (2), suitable for counting the number of pulses of the light source based on the signal sent by the interface (2) and suitable for calculating the consumption and/or production of electrical energy over a defined unit of time;
- processing and transmission means (4) coupled to the pulse counter (3); and
- a display unit (5), the processing and transmission means (4) being suitable for sending the data, related to the pulse count and to the consumption and/or production of electrical energy, to said unit (5);
- an auxiliary sensor (104) suitable for detecting the quantity of energy available at the energy generation plant (100) in a manner independent of said plant and comparing the energy available with that actually transformed and passed on to the electronic meter (CE).

2. A device (1) according to Claim 1, in which the sensor (15) of the optical interface (2) is a photodiode.

3. A device (1) according to either Claim 1 or Claim 2, in which the optical interface (2) includes a support (7) comprising a shielding (8, 16, 11), the sensor (15) being presented to the light source in one direction and shielded by the shielding in the other directions.

4. A device (1) according to one or more of the preceding claims, in which the processing and transmission means (4) include a radio or power line communication transmitter (19).

5. A device (1) according to one or more of the preceding claims, in which the display unit (5) comprises a load management control unit (30) connected to an electrical socket (31), the control unit (30) being suitable for disconnecting a load (32) connected to the socket (31) when the consumption of electrical energy is greater than a preset threshold.

6. A device (1) according to one or more of the preceding claims, in which the auxiliary sensor (104) comprises a radiation sensor in the case of a photovoltaic plant or an anemometer in the case of a wind turbine.

7. A device (1) according to Claim 7, in which the auxiliary sensor (104) includes a radiation sensor (107) and a radio or power line communication transmitter (120) capable of remotely connecting with the processing and transmission means (4) and/or with the display unit (5).

8. A device (1) according to Claim 8, in which the radiation sensor (107) is fitted in a watertight box (106) which contains, in addition to the sensor (107) and the transmitter (120), a photovoltaic panel (108) to power the same auxiliary sensor.

9. A device (1) according to one or more of the preceding claims, including alarm means (300) suitable for flagging a possible fault in the operation of the energy generation plant (100).

10. A photovoltaic plant (100), including a device in accordance with one or more of Claims 1 to 9.

11. A method for monitoring the consumption and/or production of electrical energy, by monitoring an electrical energy meter (CE) including at least one light source, said source emitting a light pulse as a function of the quantity of electrical energy produced and/or consumed, comprising the stages of:
- detecting, by means of a sensor (15), the pulses produced by the light source;
- counting the number of light pulses over a given time interval;
- calculating the consumption and/or production of electrical energy over said defined unit of time;
- sending the electrical energy consumption and/or production data to a display unit (5);
- detecting by means of an auxiliary sensor (104) the energy available from an energy generation plant (100) in a manner independent of said plant,
- comparing an energy measurement of the auxiliary sensor (104) with the energy measurement available at the electronic meter (CE) by means of said count, thus calculating the energy efficiency of the plant in terms of the energy produced at the meter (CE) with respect to the energy available at the energy generation plant (100),
- displaying said electrical energy consumption and/or production data.

12. A method according to Claim 11, in which said sending of data takes place by radio waves or by power line communication.

13. A method according to either Claim 11 or Claim 12, comprising the stage of shielding said sensor from light sources that are different from said light source present in the meter (CE).

14. A method according to one or more of Claims 11 to 13, including the stage of disconnecting at least one load (32) from an electrical plant when the energy consumption is greater than a preset threshold.

15. A method according to one or more of Claims 11 to 14, including the stage of generating an alarm signal when the result of said comparison is below an energy threshold value.
